# EUROPÄISCHE PATENTANMELDUNG

(11) **EP 2 910 956 A1**
(43) Veröffentlichungstag der Anmeldung: **26.08.2015**
(21) Anmeldenummer: 15152007.9
(22) Anmeldetag: 21.01.2015
(51) Int. Cl.: G01R 15/20

(54) **Strommesseinrichtung**

(30) Priorität: 21.01.2014 DE 102014100668
(71) Anmelder: Comexio GmbH, 67304 Kerzenheim (DE)
(72) Erfinder: Christmann, Marc, 67304 Kerzenheim (DE)
(74) Vertreter: Katscher Habermann Patentanwälte

(57) **Zusammenfassung**

Eine Strommesseinrichtung (1, 22) für eine elektrische Leiterschiene (8, 9, 23, 24) mit einem Hall-Sensor (13, 14) weist eine Aufnahmeeinrichtung (2) zur Aufnahme der elektrischen Leiterschiene (8, 9, 23, 24) und mindestens einen ersten Größensensor auf, der in einer ersten Richtung beabstandet zu dem Hall-Sensor (13, 14) an der Aufnahmeeinrichtung (2) festgelegt ist. Die Aufnahmeeinrichtung (2) weist eine Anschlageinrichtung zur Vorgabe einer Messposition der elektrischen Leiterschiene (8, 9, 23, 24) in der Aufnahmeeinrichtung (2) auf. Weiterhin weist die Strommesseinrichtung (1, 22) mindestens einen zweiten Größensensor auf, der in einer zweiten Richtung beabstandet zu dem Hall-Sensor (13, 14) an der Aufnahmeeinrichtung (2) festgelegt ist. Die Aufnahmeeinrichtung (2) besteht aus einem Aufnahmeelement (3) und einem an dem Aufnahmeelement (3) festlegbares Halteelement 6. Das Aufnahmeelement (3) weist eine U-förmige Formgebung mit zwei beabstandet zueinander angeordneten Schenkeln (4) und mit einem die Schenkel (4) verbindenden Verbindungselement (5) auf, wobei der Hall-Sensor (13, 14) an einem Schenkel (4) in der Nähe des Verbindungselements (5) angeordnet ist. Das Verbindungselement (5) ist stufenförmig ausgebildet. Der mindestens eine erste Größensensor und der mindestens eine zweite Größensensor ist jeweils ein Hall-Sensor (15, 16, 17). (Fig. 1)

## Beschreibung

Die Erfindung betrifft eine Strommesseinrichtung für eine elektrische Leiterschiene mit einem Hall-Sensor.

Aus der Praxis sind zahlreiche Messeinrichtungen für einen elektrischen Stromfluss bekannt, die auf ganz unterschiedlichen physikalischen Messprinzipien beruhen können. Mobile Strommesseinrichtungen weisen üblicherweise eine transportable Bedieneinheit und mindestens einen Messfühler auf, der an einer beliebigen Stelle innerhalb eines Stromkreises positioniert und den dort messbaren Stromfluss erfassen kann. In größeren elektrischen Anlagen mit gegebenenfalls mehreren elektrischen Verbrauchern können auch Strommesseinrichtungen ortsfest eingebaut sein, um bei Bedarf oder kontinuierlich einen Stromfluss messen und gegebenenfalls anzeigen zu können.

Strommesseinrichtungen, die einen Hall-Sensor aufweisen, ermöglichen eine in vielen Fällen vorteilhafte berührungslose Messung des Stromflusses durch einen elektrischen Leiter, ohne den zu messenden Stromfluss nennenswert zu beeinflussen oder durch die Messung zu verändern. Der Hall-Sensor erfasst ein durch den Stromfluss erzeugtes Magnetfeld. Aus der mit dem Hall-Sensor gemessenen Magnetfeldstärke kann der Stromfluss ermittelt werden, sofern der Proportionalitätsfaktor bekannt ist und sichergestellt wird, dass die gesamte Magnetfeldstärke erfasst wird, die von dem zu messenden Stromfluss erzeugt wird. Die aus der Praxis bekannten Strommesseinrichtungen mit einem Hall-Sensor weisen üblicherweise einen ringförmigen Messfühler auf, der einen ausreichend kleinen elektrischen Leiter vollständig umgibt.

Bei Mittelspannungsanlagen und Hochspannungsanlagen werden oftmals elektrische Leiterschienen als Stromleiter eingesetzt. Die Leiterschienen weisen eine rechteckige Querschnittsfläche auf, für die normierte Abmessungen wie beispielsweise 5 mm x 20 mm, 5 mm x 30 mm oder 10 mm x 20 mm vorgegeben sind. Die elektrischen Leiterschienen bestehen üblicherweise aus Kupfer oder aus einem Material mit vergleichbarer Leitfähigkeit, wobei die Leiterschiene in den meisten Fällen starr ausgebildet und im Gegensatz zu dünnem Elektrokabel nur mit erheblichem Kraftaufwand verformbar ist.

Auf Grund der großen Querschnittsfläche der elektrischen Leiterschienen ist es mit vertretbarem konstruktivem Aufwand und bei Verwendung von handelsüblichen Hall-Sensoren kaum möglich, das von der elektrischen Leiterschiene erzeugte Magnetfeld vollständig zu erfassen. Mit dem Hall-Sensor kann regelmäßig nur ein Anteil des Magnetfelds erfasst werden, der in einem Erfassungsbereich in der unmittelbaren Umgebung des Hall-Sensors erzeugt wird. Sofern die Abmessungen der elektrischen Leiterschiene bzw. deren Querschnittsfläche sowie ein für die vorgegebene Anordnung des Hall-Sensors relativ zu der elektrischen Leiterschiene charakteristischer Proportionalitätsfaktor bekannt sind, kann aus den mit dem Hall-Sensor gemessenen Werten das gesamte Magnetfeld und damit der gesamte Stromfluss durch die elektrische Leiterschiene ermittelt werden. Der Proportionalitätsfaktor kann für eine vorgegebene Konfiguration experimentell ermittelt und in der Strommesseinrichtung hinterlegt sein.

Eine derart kalibrierte Strommesseinrichtung kann den Stromfluss einer elektrischen Leiterschiene mit den passenden Abmessungen rasch und präzise messen, sofern der Hall-Sensor relativ zu der elektrischen Leiterschiene richtig positioniert ist und die tatsächliche räumliche Anordnung mit der für die vorausgegangene Kalibration verwendeten Anordnung übereinstimmt. Es ist jedoch nicht möglich, mit einer aus der Praxis bekannten Strommesseinrichtung mit einem Hall-Sensor den Stromfluss einer elektrischen Leiterschiene richtig zu erfassen, deren Abmessungen nicht bekannt sind bzw. die verschiedene Abmessungen aufweisen kann.

Dies führt dazu, dass für die verschiedenen normierten Querschnittsflächen und Abmessungen der elektrischen Leiterschienen jeweils gesonderte Strommesseinrichtungen hergestellt bzw. kalibriert werden müssen. In einer Stromverteilungsanlage, in der verschiedene elektrische Leiterschienen eingesetzt werden und der Stromfluss an verschiedenen Stellen bzw. von verschiedenen elektrischen Leiterschienen gemessen werden soll, sind die Verwendung und die richtige Anordnung verschiedener Strommesseinrichtungen erforderlich. Der Aufwand für die Herstellung von Strommesseinrichtungen für die verschiedenen elektrischen Leiterschienen und für deren Montage in den Stromverteilungsanlagen ist erheblich. Hinzu kommt ein Risiko, das trotz größter Sorgfalt während der Montage und des Betriebs der Stromverteilungsanlage eine Strommesseinrichtung falsch installiert oder mit einer unzutreffenden Kalibrierung oder Konfiguration betrieben wird. Insbesondere bei sicherheitsrelevanten Stromverteilungsanlagen ist eine zuverlässige Kontrolle und Überwachung des Stromflusses in einzelnen elektrischen Leiterschienen eine wichtige Voraussetzung für den fehlerfreien und sicherheitsbewussten Betrieb dieser Anlagen.

Es wird deshalb als eine Aufgabe der vorliegenden Erfindung angesehen, eine Strommesseinrichtung für elektrische Leiterschienen so auszugestalten, dass mit einem möglichst geringen konstruktiven Aufwand eine möglichst zuverlässige Ermittlung des Stromflusses bei verschiedenen elektrischen Leiterschienen möglich ist.

Diese Aufgabe wird erfindungsgemäß dadurch gelöst, dass die Strommesseinrichtung eine Aufnahmeeinrichtung zur Aufnahme der elektrischen Leiterschiene und mindestens einen ersten Größensensor aufweist, der in einer ersten Richtung beabstandet zu dem Hall-Sensor an der Aufnahmeeinrichtung festgelegt ist, wobei mit dem Größensensor eine Information über die Erstreckung der elektrischen Leiterschiene in der ersten Richtung erhalten werden kann. Durch die Aufnahmeeinrichtung kann eine zuverlässige Positionierung der für die Strommessung vorgesehenen elektrischen Leiterschiene relativ zu dem Hall-Sensor vorgegeben werden. Durch den ersten Größensensor kann eine Information über die Erstreckung der elektrischen Leiterschiene in der ersten Richtung und dadurch gegebenenfalls über die Abmessungen erhalten werden bzw. eine Auswahl aus verschiedenen genormten oder vorgegebenen Leiterschienenabmessungen erfolgen, die für die Ermittlung des mit dem Hall-Sensor gemessenen Stromflusses relevant sind.

Der erste Größensensor kann beispielsweise ein Mikroschalter sein, mit dem festgestellt werden kann, ob sich die elektrische Leiterschiene in der ersten Richtung bis über die Position des Mikroschalters hinaus erstreckt. Mit einem Mikroschalter können zuverlässig zwei unterschiedliche Breiten oder Dicken der elektrischen Leiterschienen unterschieden werden.

Es ist ebenfalls denkbar, dass der erste Größensensor die Erstreckung der elektrischen Leiterschiene in der ersten Richtung ermitteln und in Abhängigkeit von der ermittelten Größe der elektrischen Leiterschiene ein diese Größe repräsentierendes Messsignal erzeugen kann. In diesem Fall könnte mit einem einzigen ersten Größensensor eine beliebige Erstreckung der elektrischen Leiterschiene in der ersten Richtung zuverlässig bestimmt und für die Auswertung der Messergebnisse des Hall-Sensors verwendet werden.

Mit der erfindungsgemäßen Strommesseinrichtung kann auch der Stromfluss in elektrischen Leiterschienen ermittelt werden, die keine rechteckige Querschnittsfläche aufweisen. Mit einer geeigneten Aufnahmeeinrichtung könnten auch elektrische Leiterschienen mit einer kreisförmigen Querschnittsfläche zuverlässig relativ zu dem Hall-Sensor positioniert und nach einer Ermittlung des Durchmessers der Leiterschiene der gesamte Stromfluss gemessen werden.

Um die Positionierung der elektrischen Leiterschiene in der Aufnahmeeinrichtung zu erleichtern ist vorgesehen, dass die Aufnahmeeinrichtung eine Anschlageinrichtung zur Vorgabe einer Messposition der elektrischen Leiterschiene in der Aufnahmeeinrichtung aufweist. Die Anschlageinrichtung kann eine vorspringende Anschlagfläche sein. Es ist ebenfalls möglich, dass die Aufnahmeeinrichtung eine Ausnehmung aufweist, in welche die elektrische Leiterschiene eingelegt oder eingebracht werden kann. Es können auch mehrere Ausnehmungen oder Anschlageinrichtungen um den Hall-Sensor herum angeordnet sein.

Um eine möglichst vollständig automatisierte Größenermittlung der elektrischen Leiterschiene durch die Strommesseinrichtung zu ermöglichen ist vorgesehen, dass die Strommesseinrichtung mindestens einen zweiten Größensensor aufweist, der in einer zweiten Richtung beabstandet zu dem Hall-Sensor an der Aufnahmeeinrichtung festgelegt ist. Durch die Anordnung eines ersten Größensensors in einer ersten Richtung und eines zweiten Größensensors in einer zweiten Richtung kann die Erstreckung der elektrischen Leiterschiene in zwei verschiedenen Richtungen ermittelt werden. Zweckmäßigerweise sind die erste Richtung und die zweite Richtung rechtwinklig zueinander vorgegeben. Durch eine geeignete Anordnung des ersten Größensensors und des zweiten Größensensors können mit geringem konstruktiven Aufwand verschiedene Querschnittsflächen von elektrischen Leiterschienen automatisiert bestimmt und für die Auswertung der Messwerte des Hall-Sensors verwendet werden. Eine manuelle Eingabe oder Vorgabe von Abmessungen und Querschnittsflächentypen der elektrischen Leiterschiene, die mit der Strommesseinrichtung gemessen werden soll, ist nicht erforderlich.

Zweckmäßigerweise ist vorgesehen, dass der erste Größensensor und der zweite Größensensor jeweils einen Abstand zu dem Hall-Sensor aufweisen, der größer als die Erstreckung einer kleinen elektrischen Leiterschiene in diese Richtung und kleiner als die Erstreckung einer großen elektrischen Leiterschiene in dieser Richtung sind. Eine kleine elektrische Leiterschiene ist eine Leiterschiene, die zumindest in der betreffenden Richtung eine kleinere Erstreckung als eine größere Leiterschiene aufweist, wobei beide Leiterschienen mit der Strommesseinrichtung präzise erfasst und ein durch diese Leiterschienen fließender Strom mit hoher Genauigkeit vermessen werden kann.

Durch die Anordnung des ersten Größensensors und des zweiten Größensensors in einen Bereich, der eine möglichst zuverlässige Unterscheidung zwischen verschiedenen Größen der elektrischen Leiterschienen ermöglicht, wird die Zuverlässigkeit und Genauigkeit der Größenbestimmung der in der Aufnahmeeinrichtung angeordneten elektrischen Leiterschiene und damit auch die Genauigkeit der Strommessung verbessert.

Bei Mittelspannungsanlagen und bei Hochspannungsanlagen werden häufig elektrische Leiterschienen mit einer rechteckigen Querschnittsfläche verwendet. Um derartige Leiterschienen besonders zuverlässig aufnehmen und mit der Strommesseinrichtung vermessen zu können ist vorgesehen, dass die Aufnahmeeinrichtung eine ebene Anlagefläche und längs einer Seitenkante der Anlagefläche eine Anschlagsbegrenzung aufweist. Die Leiterschiene mit einer rechteckigen Querschnittsfläche kann mit einer Breitseite an die Anlagefläche angelegt werden. Für eine zuverlässige Positionierung der Leiterschiene muss dann lediglich eine Seitenfläche der Leiterschiene an die Anschlagsbegrenzung herangeführt bzw. angedrückt werden. Die Montage einer Strommesseinrichtung mit einer derartigen Aufnahmeeinrichtung ist vergleichsweise einfach und fehlersicher.

Es ist ebenso möglich, dass die Aufnahmeeinrichtung eine Ausnehmung mit einer seitlichen Anschlagsbegrenzung aufweist, in der eine elektrische Leiterschiene aufnehmbar ist. Die seitliche Anschlagbegrenzung kann sowohl für eine rechteckige Querschnittsfläche als auch für eine runde Querschnittsfläche ausgestaltet sein.

Um die Anordnung und Festlegung der Strommesseinrichtung an einer elektrischen Leiterschiene zu erleichtern, ist vorgesehen, dass die Aufnahmeeinrichtung ein Aufnahmeelement und ein an dem Aufnahmeelement festlegbares Halteelement aufweist. Das Halteelement kann schwenkbar oder lösbar mit dem Aufnahmeelement verbunden sein. Das Halteelement kann beispielsweise rastend oder klemmend an dem Aufnahmeelement festgelegt werden, um die zwischen dem Aufnahmeelement und dem Halteelement befindliche Leiterschiene in der vorgesehenen Messposition in der Aufnahmeeinrichtung zu fixieren.

Gemäß einer besonders vorteilhaften Ausgestaltung des Erfindungsgedankens ist vorgesehen, dass das Aufnahmeelement eine U-förmige Formgebung mit zwei beabstandet zueinander angeordneten Schenkeln und mit einem die Schenkel verbindenden Verbindungselement aufweist. Eine elektrische Leiterschiene mit einer rechteckigen Querschnittsfläche kann zwischen die Schenkel des Aufnahmeelements eingeschoben und zwischen den Schenkeln festgelegt werden. Das Verbindungselement kann eine Anschlagsbegrenzung bilden und die Messposition der Leiterschiene zwischen den beiden Schenkeln vorgeben.

Erfindungsgemäß ist vorgesehen, dass der Hall-Sensor an einem Schenkel in der Nähe des Verbindungselements angeordnet ist. Durch die Anordnung des Hall-Sensors in einem Schenkel in der Nähe des Verbindungselements wird sichergestellt, dass unabhängig von der Größe der Leiterschiene der Hall-Sensor zumindest einen Teil des Magnetfelds erfassen kann, das durch einen Stromfluss durch die Leiterschiene hindurch erzeugt wird.

Es ist ebenfalls erfindungsgemäß möglich, dass der Hall-Sensor an dem Verbindungselement angeordnet ist. Durch die Anordnung des Hall-Sensors an dem Verbindungselement kann zumindest einen Teil des Magnetfelds beispielsweise bei anderer Geometrie der Querschnittsfläche erfasst werden.

Zweckmäßigerweise wird ein erster Größensensor beabstandet zu dem Hall-Sensor in demselben Schenkel angeordnet und ein zweiter Größensensor beabstandet zu dem Hall-Sensor in dem Verbindungselement angeordnet. Durch den ersten Größensensor und den zweiten Größensensor können dann die Breite und die Dicke einer Leiterschiene mit einer rechteckigen Querschnittsfläche ermittelt werden.

In den meisten Anwendungsfällen weisen die normierten elektrischen Leiterschienen lediglich zwei oder drei verschiedene Dicken auf. Um jeweils eine eindeutige Positionierung zuverlässig vorgeben zu können ist vorgesehen, dass das Verbindungselement stufenförmig ausgebildet ist. Eine Leiterschiene mit einer ersten, geringen Dicke kann maximal zwischen den Schenkeln zu dem Verbindungselement hin eingeschoben und in einer ersten Messposition festgelegt werden. Eine Leiterschiene mit einer größeren Dicke wird von einem stufenförmigen Vorsprung, der an dem Verbindungselement ausgebildet ist, in einem durch den stufenförmigen Vorsprung vorgegebenen Abstand von der ersten Messposition zurückgehalten und festgelegt. Sofern die Strommesseinrichtung für weitere Dickenwerte von derartigen Leiterschienen vorgesehen ist, können weitere stufenförmige Vorsprünge an dem Verbindungselement ausgebildet sein.

In vorteilhafter Weise ist vorgesehen, dass der zweite Größensensor im Bereich der ersten Stufe des Verbindungselements angeordnet ist. Der zweite Größensensor kann dabei so angeordnet und ausgestaltet sein, dass der zweite Größensensor erkennen kann, ob in einer durch die erste Stufe begrenzten Ausnehmung eine Leiterschiene eingeführt und angeordnet ist, oder ob die Leiterschiene zu dick ist und deshalb nicht in die von der ersten Stufe gebildete Ausnehmung hineinragen kann.

Um die Zuverlässigkeit und Genauigkeit der Messergebnisse der Strommesseinrichtung zu verbessern ist vorgesehen, dass mehrere erste Größensensoren in der ersten Richtung beabstandet zueinander angeordnet sind. Die mehreren ersten Größensensoren können jeweils unabhängig voneinander ein Messergebnis für die in dieser Richtung ermittelte Größe der elektrischen Leiterschiene liefern. Durch eine geeignete Auswertung kann die Präzision der Größenmessung in dieser ersten Richtung verbessert werden.

Es ist ebenfalls möglich, dass die ersten Größensensoren jeweils paarweise eng beieinander angeordnet sind und die beiden Messsignale der paarweise einander zugeordneten ersten Größensensoren ausgewertet und auf mögliche Fehlmessungen überprüft werden, um erwünschte Schwankungen oder Störsignale während einer Messung identifizieren und ausschließen zu können.

In gleicher Weise kann vorgesehen sein, dass mehrere zweite Größensensoren in der zweiten Richtung beabstandet zueinander angeordnet sind.

In der Praxis kann in Abhängigkeit von der Vielfalt von Querschnittsflächen der Leiterschienen, für welche die Strommesseinrichtung geeignet sein und verwendet werden soll, eine mehr oder wenige große Anzahl von ersten Größensensoren und zweiten Größensensoren verwendet werden. Mit zunehmender Anzahl von ersten und zweiten Größensensoren kann die Präzision der Strommessung und die Zuverlässigkeit bei der Erkennung der Querschnittsfläche der elektrischen Leiterschiene verbessert werden. Gleichzeitig nehmen auch der konstruktive Aufwand und die Herstellungskosten für die Strommesseinrichtung zu.

Gemäß einer besonders vorteilhaften Ausgestaltung des Erfindungsgedankens ist vorgesehen, dass der mindestens eine erste Größensensor und/oder der mindestens eine zweite Größensensor ein Hall-Sensor ist. Durch die Verwendung gleichartiger Sensoren bzw. baugleicher Hall-Sensoren können die Herstellungskosten verringert, der Aufwand für die Kalibration und Auswertung der Sensoren reduziert und die Präzision der Strommessung verbessert werden. Durch die ausschließliche Verwendung von Hall-Sensoren ist eine Strommessung ohne eine elektrisch leitende Kontaktierung der elektrischen Leiterschiene möglich. Durch die Einbettung der Hall-Sensoren in ein geeignetes Isoliermaterial können nachteilige Wechselwirkungen zwischen einer stromdurchflossenen Leiterschiene und einer Strommesseinrichtung während des Betriebs vermieden werden.

Es ist vorgesehen, dass die Strommesseinrichtung eine Zeitgebereinrichtung aufweist. Die mit der Strommesseinrichtung gemessenen Signale des Hall-Sensors können mit einem Zeitsignal kombiniert werden und in dieser Kombination einer Auswerteeinrichtung zugeführt werden. In der Auswerteeinrichtung kann dann nicht nur eine präzise Erfassung des Stromflusses durch die elektrische Leiterschiene erfolgen, sondern auch ein zeitlicher Verlauf des Stromflusses aufgezeichnet oder eine Leistungsbestimmung durchgeführt werden.

Gemäß einer besonders vorteilhaften Ausführung des Erfindungsgedankens ist vorgesehen, dass die Strommesseinrichtung eine Schnittstelle für ein Bus-System aufweist. Über diese Schnittstelle kann die Strommesseinrichtung an ein Bus-System angeschlossen werden und über das Bus-System mit einer beabstandet von der Strommesseinrichtung angeordneten Auswerteeinrichtung verbunden sein. Es ist jedenfalls möglich, eine große Anzahl von Strommesseinrichtungen über das Bus-System mit einer einzigen Auswerteeinrichtung zu verbinden. Insbesondere bei größeren Stromverteilungsanlagen, die mehrere oder eine große Anzahl von Strommesseinrichtungen aufweisen, kann dadurch eine erhebliche Verringerung des konstruktiven Aufwands und damit der Herstellungs- und Montagekosten erreicht werden.

Nachfolgend werden Ausführungsbeispiele des Erfindungsgedankens näher erläutert, die in der Zeichnung dargestellt sind. Es zeigt:
- Figur 1: eine schematische Schnittansicht einer erfindungsgemäßen Strommesseinrichtung mit einem Aufnahmeelement, mit einem daran festlegbaren Halteelement und mit einer darin angeordneten ersten Leiterschiene,
- Figur 2: eine schematische Darstellung der Strommesseinrichtung gemäß Figur 1, wobei eine zweite elektrische Leiterschiene mit einer abweichenden Querschnittsfläche in der Strommesseinrichtung festgelegt ist,
- Figur 3: eine schematische Darstellung mehrerer Strommesseinrichtungen, die über ein Bus-System mit einer gemeinsamen Auswerteeinrichtung verbunden sind,
- Figur 4: eine schematische Darstellung einer erfindungsgemäßen Strommesseinrichtung mit einem Aufnahmeelement, mit einem daran festlegbaren Halteelement und mit einer darin angeordneten Leiterschiene mit einer kreisrunden Querschnittsfläche, und
- Figur 5: eine schematische Darstellung der Strommesseinrichtung gemäß Figur 4, wobei eine elektrische Leiterschiene mit einer kreisrunden Querschnittsfläche mit einem anderen Durchmesser als in Figur 4 in der Strommesseinrichtung festgelegt ist.

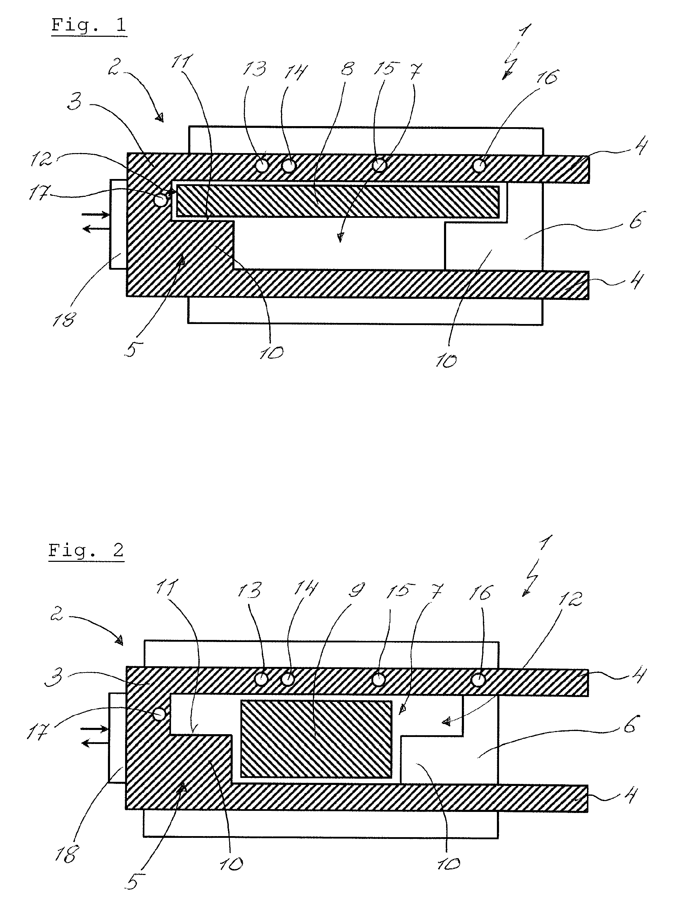

Eine in den Figuren 1 und 2 schematisch dargestellte Strommesseinrichtung 1 beinhaltet eine aus zwei Teilen bestehende Aufnahmeeinrichtung 2. Die Aufnahmeeinrichtung 2 weist ein im Wesentlichen U-förmiges Aufnahmeelement 3 mit zwei beabstandet zueinander angeordneten Schenkeln 4 und mit einem die Schenkel 4 verbindenden Verbindungselement 5 auf. Die Aufnahmeeinrichtung 2 umfasst weiterhin ein an dem Aufnahmeelement 3 formschlüssig festlegbares Halteelement 6 auf. Das Halteelement 6 ist ebenfalls näherungsweise U-förmig ausgestaltet, jedoch in entgegengesetzter Richtung relativ zu dem Aufnahmeelement 3 angeordnet, bzw. ausgerichtet.

Das Halteelement 6 ist entlang einer durch die Schenkel 4 des Aufnahmeelements 3 vorgegebenen Richtung relativ zu dem Aufnahmeelement 3 verlagerbar und kann in verschiedenen Positionen an dem Aufnahmeelement 3 formschlüssig festgelegt werden. Das Aufnahmeelement 3 und das Halteelement 6 umschließen einen Innenraum 7, in dem sich eine erste elektrische Leiterschiene 8 (Figur 1) oder eine zweite elektrische Leiterschiene 9 (Figur 2) befinden kann.

Sowohl das Verbindungselement 5 des Aufnahmeelements 3 als auch das Halteelement 6 weisen einen hinsichtlich der jeweiligen Abmessungen aneinander angepassten stufenförmigen Vorsprung 10 auf. Der stufenförmige Vorsprung 10 bildet eine seitliche Anschlagbegrenzung 11 für eine Ausnehmung 12 in dem Verbindungselement 5 des Aufnahmeelements 3, beziehungsweise in dem Halteelement 6. Die Abmessungen der Ausnehmungen 12, beziehungsweise der stufenförmigen Vorsprünge 10 sind an aus der Praxis bekannte, normierte Querschnittsflächen der verschiedenen elektrischen Leiterschienen 8, 9 angepasst, für welche die Strommesseinrichtung 1 vorgesehen ist.

Die erste elektrische Leiterschiene 8 weist eine geringe Dicke auf und kann in die Ausnehmungen 12 hineingeschoben werden. Eine Breite der ersten elektrischen Leiterschiene 8 ist vergleichsweise groß, so dass das Halteelement 6 in einer auseinandergezogenen Position der Aufnahmeeinrichtung 2 an dem Aufnahmeelement 3 festgelegt ist und die erste elektrische Leiterschiene 8 klemmend umgibt.

Die zweite elektrische Leiterschiene 9 weist ein verglichen mit der ersten elektrischen Leiterschiene 8 größere Dicke auf und kann deshalb nicht in die Ausnehmung 12 hineingeschoben werden. Vielmehr liegt die zweite elektrische Leiterschiene 9 mit einer Seitenkante an dem stufenförmigen Vorsprung 10 des Verbindungselements 5 an. In gleicher Weise bildet der stufenförmige Stufenvorsprung 10 des Halteelements 6 einen Anschlag für die gegenüberliegende Seitenkante der zweiten elektrischen Leiterschiene 9. Aufgrund der im Vergleich zu der ersten elektrischen Leiterschiene 8 geringeren Breite der zweiten elektrischen Leiterschiene 9 können das Halteelement 6 und das Aufnahmeelement 3 der Aufnahmeeinrichtung 2 enger zusammengeschoben werden, bevor die zweite elektrische Leiterschiene 9 in dem Innenraum 7 der Aufnahmeeinrichtung 2 eng umschlossen festgelegt wird.

Die Aufnahmeeinrichtung 2 kann dem zu Folge sowohl die erste elektrische Leiterschiene 8 als auch die zweite elektrische Leiterschiene 9 an einer für die jeweilige Leiterschiene 8, 9 charakteristischen und eindeutig vorgegebenen Position zuverlässig aufnehmen.

In dem Aufnahmeelement 3 ist in dem der Ausnehmung 12 zugeordneten Schenkel 4 in der Nähe des Verbindungselements 5 ein erster Hall-Sensor 13 angeordnet. Unmittelbar neben dem ersten Hall-Sensor 13 ist ein zweiter Hall-Sensor 14 angeordnet. Die Position des ersten Hall-Sensors 13 und des zweiten Hall-Sensors 14 ist so gewählt, dass unabhängig von der Querschnittsfläche der in dem Innenraum 7 befindlichen Leiterschiene 8, 9 jeweils eine möglichst große Magnetfeldstärke der stromdurchflossenen Leiterschiene 8, 9 erfasst und gemessen werden kann. Die beiden Hall-Sensoren 13 und 14 sollen aufgrund ihrer Anordnung im Wesentlichen vergleichbare Magnetfeldstärken erfassen und messen, so dass die Messsignale der beiden Hall-Sensoren gemittelt werden können und dadurch die Genauigkeit der mit den beiden Hall-Sensoren 13, 14 durchgeführten Magnetfeldmessungen verbessert werden kann.

In einer ersten Richtung, die durch die Ausrichtung der Schenkel 4 des Aufnahmeelements 3 vorgegeben ist, befinden sich beabstandet zu dem ersten Hall-Sensor 13 zwei weitere Hall-Sensoren 15, 16, die als erste Größensensoren 15, 16 verwendet werden. In Abhängigkeit von der in dem Innenraum 7 befindlichen Leiterschiene 8, 9 wird mit dem am weitesten von dem ersten Hall-Sensor 13 entfernten Hall-Sensor 16 bei der ersten elektrischen Leiterschiene 8 ebenfalls ein Magnetfeld gemessen, während bei der zweiten Leiterschiene 9 kein nennenswertes Magnetfeld trotz eines bestehenden Stromflusses nachgewiesen werden kann. Über die mit den Hall-Sensoren 15 und 16 jeweils nachgewiesenen Magnetfeldstärken kann zwischen den verschiedenen Breiten der elektrischen Leiterschienen 8 und 9 unterschieden werden.

In dem Verbindungselement 5 ist im Bereich der Ausnehmung 12 ein weiterer Hall-Sensor 17 angeordnet, der einen in einer zweiten Richtung senkrecht zu den Schenkeln 4 einen zweiten Größensensor 17 darstellt. Mit dem Hall-Sensor 17 kann festgestellt werden, ob die erste elektrische Leiterschiene 8 mit einer geringen Dicke in die Ausnehmung 12 bis in die Nähe des Hall-Sensors 17 hineingeschoben ist, oder ob die wesentlich dickere zweite Leitschiene 9 durch den stufenförmigen Vorsprung 10 in einem deutlich messbaren Abstand zu dem Hall-Sensor 17 in dem Innenraum 7 festgelegt ist.

Durch eine Auswertung der Messsignale der Hall-Sensoren 15, 16 und 17, die erste Größensensoren 15, 16 und zweite Größensensoren 17 darstellen, kann auf die Querschnittsfläche der in dem Innenraum 7 befindlichen elektrischen Leiterschiene 8, 9 geschlossen werden.

In Kenntnis der Querschnittsfläche der jeweiligen Leiterschiene 8 oder 9 können die Messsignale der Hall-Sensoren 13 und 14 ausgewertet werden. Durch eine vorausgegangene Kalibration können die mit den Hall-Sensoren 13 und 14 gemessenen Magnetfeldstärken bei einer bekannten Querschnittsfläche des elektrischen Leiters 8 oder 9 mit hoher Präzision in einen Stromfluss umgerechnet werden, der für die Erzeugung des gemessenen Magnetfelds verantwortlich ist.

Auf diese Weise ist es mit der erfindungsgemäßen Strommesseinrichtung 1 möglich, automatisch zwischen verschiedenen normierten Leiterschienen 8, 9 zu unterscheiden und in Abhängigkeit von der in dem Innenraum 7 aufgenommenen Leiterschiene 8 oder 9 ausgehend von der mit den Hall-Sensoren 13, 14 gemessenen Magnetfeldstärke den verursachenden Stromfluss zu ermitteln.

Es können weitere erste Größensensoren oder zweite Größensensoren in den Schenkeln 4, beziehungsweise in dem Verbindungselement 5 angeordnet sein. Das Verbindungselement 5 kann weitere stufenförmige Vorsprünge 10 aufweisen, so dass mehr als zwei verschiedene Querschnittsflächen in der Aufnahmeeinrichtung 2 aufgenommen werden können. Die Präzision der Strommessung kann durch die Anordnung weiterer Hall-Sensoren 13, 14 im Bereich der elektrischen Leiterschienen 8, 9 verbessert werden.

Die Strommesseinrichtung 1 weist eine Schnittstelle 18 zur Anbindung der Strommesseinrichtung 1 an ein Bus-System 19 auf.

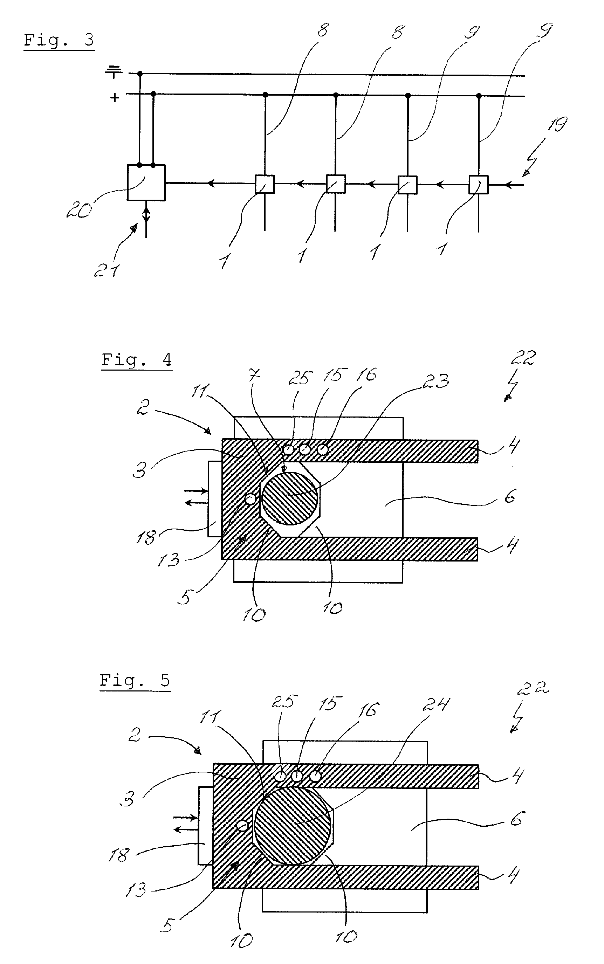

Lediglich exemplarisch ist ein Teilbereich eines derartigen Bus-Systems 19 in Figur 5 dargestellt. Mehrere Strommesseinrichtungen 1 sind in Reihe geschaltet in das Bus-System 19 eingebunden. Die Messsignale der einzelnen Strommesseinrichtungen 1 werden zusammen mit einer Zeitinformation an eine zentrale Auswerteeinrichtung 20 übermittelt. Mit der Auswerteeinrichtung 20 können nicht nur die einzelnen Stromstärken, die mit den jeweiligen Strommesseinrichtungen 1 gemessen wurden, zentral erfasst und über eine drahtgebundene oder drahtlose Schnittstelle 21 beispielsweise über das Internet oder zu einer Speichereinrichtung übermittelt werden, sondern auch Leistungsmessungen durchgeführt und die zu verschiedenen Zeitpunkten ermittelten Stromstärken über einen vorgebbaren Zeitraum integriert und ausgewertet werden.

Figur 4 und Figur 5 zeigen eine schematische Darstellung einer Strommesseinrichtung 22. Die Strommesseinrichtung 22 ist für die Aufnahme und Vermessung von elektrischen Leiterschienen mit einer runden, bzw. kreisförmigen Querschnittsfläche geeignet und vorgesehen. In Figur 4 ist exemplarisch eine erste elektrische Leiterschiene 23 mit einer vergleichsweise kleinen kreisrunden Querschnittsfläche in der Aufnahmeeinrichtung 2 dargestellt, und in Figur 5 ist exemplarisch eine zweite Leiterschiene 24 mit einer verglichen mit Figur 4 größeren kreisrunden Querschnittsfläche in der Strommesseinrichtung 22 festgelegt. Die im Vergleich zu der in den Figuren 1 und 2 dargestellten Ausführungsform abweichend ausgestaltete Aufnahmeeinrichtung 2 weist ebenfalls eine Ausnehmung 12 mit den zwei seitlichen Anschlagbegrenzungen 11 auf, sodass die Leiterschienen 23 und 24 mit einer kreisrunden Querschnittsfläche auf eine einfache Weise in der Strommesseinrichtung 22 festgelegt werden können.

Der Hall-Sensor 13 ist an dem Verbindungselement 5 angeordnet und gewährleistet eine Erfassung des Magnetfelds unabhängig von der Querschnittsfläche der runden elektrischen Leiterschienen 23 und 24. Der erste Größensensor 15 und der zweite Größensensor 16 sowie ein weiterer Größenmesssensor 25 sind in diesem Ausführungsbeispiel an dem Schenkel 4 der Strommesseinrichtung 22 festgelegt, wobei durch eine Messung an den Größenmesssensoren 15, 16 und 25 die Querschnittsfläche der runden Leiterschienen 23 und 24 ermittelt und für eine Bestimmung des zu messenden Stromflusses verwendet werden kann.

## Patentansprüche

1. Strommesseinrichtung (1, 22) für eine elektrische Leiterschiene (8, 9, 23, 24) mit einem Hall-Sensor (13, 14), **dadurch gekennzeichnet, dass** die Strommesseinrichtung (1, 22) eine Aufnahmeeinrichtung (2) zur Aufnahme der elektrischen Leiterschiene (8, 9, 23, 24) und mindestens einen ersten Größensensor (15, 16, 25) aufweist, der in einer ersten Richtung beabstandet zu dem Hall-Sensor (13, 14) an der Aufnahmeeinrichtung (2) festgelegt ist, wobei mit dem ersten Größensensor (15, 16, 25) eine Information über die Erstreckung der elektrischen Leiterschiene (8, 9, 23, 24) in der ersten Richtung erhalten werden kann.

2. Strommesseinrichtung (1, 22) nach Anspruch 1, **dadurch gekennzeichnet, dass** die Aufnahmeeinrichtung (2) eine Anschlageinrichtung zur Vorgabe einer Messposition der elektrischen Leiterschiene (8, 9, 23, 24) in der Aufnahmeeinrichtung (2) aufweist.

3. Strommesseinrichtung (1, 22) nach Anspruch 1 oder Anspruch 2, **dadurch gekennzeichnet, dass** die Strommesseinrichtung (1, 22) mindestens einen zweiten Größensensor (17) aufweist, der in einer zweiten Richtung beabstandet zu dem Hall-Sensor (13, 14) an der Aufnahmeeinrichtung (2) festgelegt ist.

4. Strommesseinrichtung (1, 22) nach Anspruch 3, **dadurch gekennzeichnet, dass** der erste Größensensor und der zweite Größensensor (17) jeweils einen Abstand zu dem Hall-Sensor (13, 14) aufweisen, der größer als die Erstreckung einer kleinen elektrischen Leiterschiene (8) in dieser Richtung und kleiner als die Erstreckung einer großen elektrischen Leiterschiene (9) in dieser Richtung ist.

5. Strommesseinrichtung (1, 22) nach einem der vorangehenden Ansprüche, **dadurch gekennzeichnet, dass** die Aufnahmeeinrichtung (2) eine ebene Anlagefläche und längs einer Seitenkante der Anlagefläche eine Anschlagsbegrenzung (11) aufweist.

6. Strommesseinrichtung (1, 22) nach einem der vorangehenden Ansprüche, **dadurch gekennzeichnet, dass** die Aufnahmeeinrichtung (2) eine Ausnehmung (12) mit einer seitlichen Anschlagsbegrenzung (11) aufweist, in der eine elektrische Leiterschiene (8) aufnehmbar ist.

7. Strommesseinrichtung (1, 22) nach einem der vorangehenden Ansprüche, **dadurch gekennzeichnet, dass** die Aufnahmeeinrichtung (2) ein Aufnahmeelement (3) und ein an dem Aufnahmeelement (3) festlegbares Halteelement (6) aufweist, und dass das Aufnahmeelement (3) eine U-förmige Formgebung mit zwei beabstandet zueinander angeordneten Schenkeln (4) und mit einem die Schenkel (4) verbindenden Verbindungselement (5) aufweist.

8. Strommesseinrichtung (1, 22) nach Anspruch 7, **dadurch gekennzeichnet, dass** der Hall-Sensor (13, 14) an einem Schenkel (4) in der Nähe des Verbindungselements (5) oder an dem Verbindungselement (5) angeordnet ist.

9. Strommesseinrichtung (1, 22) nach einem der Ansprüche 7 oder 8, **dadurch gekennzeichnet, dass** das Verbindungselement (5) stufenförmig ausgebildet ist.

10. Strommesseinrichtung (1, 22) nach Anspruch 19, **dadurch gekennzeichnet, dass** der zweite Größensensor (17) im Bereich der ersten Stufe des Verbindungselements (5) angeordnet ist.

11. Strommesseinrichtung (1, 22) nach einem der vorangehenden Ansprüche, **dadurch gekennzeichnet, dass** mehrere erste Größensensoren (15, 16, 25) in der ersten Richtung beabstandet zueinander angeordnet sind und/oder dass mehrere zweite Größensensoren (17), in der zweiten Richtung beabstandet zueinander angeordnet sind.

12. Strommesseinrichtung (1, 22) nach einem der vorangehenden Ansprüche, **dadurch gekennzeichnet, dass** mindestens ein erster Größensensor (15, 16, 25) ein Hall-Sensor (15, 16, 25) und/oder dass mindestens ein zweiter Größensensor (17) ein Hall-Sensor (17) ist.

13. Strommesseinrichtung (1, 22) nach einem der vorangehenden Ansprüche, **dadurch gekennzeichnet, dass** die Strommesseinrichtung (1, 22) eine Zeitgebeeinrichtung aufweist.

14. Strommesseinrichtung (1, 22) nach einem der vorangehenden Ansprüche, **dadurch gekennzeichnet, dass** die Strommesseinrichtung (1, 22) eine Schnittstelle (18) für ein Bus-System (19) aufweist.
